# EUROPEAN PATENT APPLICATION

(11) **EP 1 696 494 A1**
(43) Date of publication of application: **30.08.2006**
(21) Application number: 04807169.0
(22) Date of filing: 16.12.2004
(51) Int. Cl.: H01L 33/00

(54) **SEMICONDUCTOR LIGHT-EMITTING DEVICE AND METHOD FOR MANUFACTURING SAME**

(30) Priority: 18.12.2003 JP 2003420923
(71) Applicant: Rohm, Co., Ltd., Kyoto-shi, Kyoto 615-0045 (JP)
(72) Inventor: ITO, Norikazu;, Kyoto-shi, Kyoto;6158585 (JP); SONOBE, Masayuki;, Kyoto-shi, Kyoto;6158585 (JP); NAKAGAWA, Daisuke;, Kyoto-shi, Kyoto;6158585 (JP)
(74) Representative: TBK-Patent
(86) International application number: PCT/JP2004/018810
(87) International publication number: WO 2005/060013

(57) **Abstract**

A semiconductor lamination portion (6) is formed by laminating at least an n-type layer (3) and a p-type layer (5) made of gallium nitride based compound semiconductor so as to form a light emitting portion, and a light transmitting conductive layer (7) is formed on a surface of the semiconductor lamination portion. An upper electrode (8) is formed so as to adhere to an exposed surface of the semiconductor lamination portion exposed by etching a part of the light transmitting conductive layer, and to the light transmitting conductive layer. An electric current blocking means (10) is formed on the exposed surface of the semiconductor lamination portion which is exposed through an opening (7a) of the light transmitting conductive layer, thereby significantly preventing electric current from flowing into a part under the upper electrode while ensuring good adhesion between the upper electrode and the surface of the semiconductor lamination portion. Consequently, there can be obtained a semiconductor light emitting device using gallium nitride based compound semiconductor wherein external quantum efficiency is improved by suppressing light emission under the upper electrode while enhancing adhesion between the upper electrode and the semiconductor layer.

## Description

### FIELD OF THE INVENTION

The present invention relates to a semiconductor light emitting device employing gallium nitride based compound semiconductor. More particularly, the present invention relates to a semiconductor light emitting device, in which an upper electrode is formed with good adhesion on a surface of a semiconductor lamination portion made of gallium nitride based compound semiconductor with which it is difficult to achieve an ohmic contact between the upper electrode made of metal and the surface of the semiconductor lamination portion, and, at the same time, in which useless emission of light is suppressed by preventing the electric current from flowing into a part under the upper electrode from which light can not be taken out, while diffusing an electric current in an entire chip, and relates to a method for manufacturing the same.

### BACKGROUND OF THE INVENTION

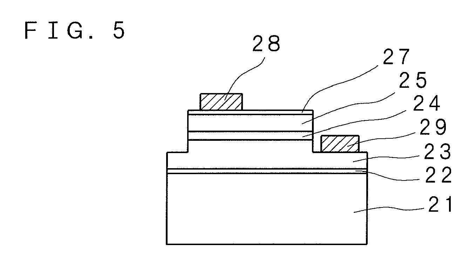

A semiconductor light emitting device employing gallium nitride based compound semiconductor by the prior art is formed, for example, in a structure shown in Fig. 5. Namely, on a sapphire substrate 21, for example, a buffer layer 22 made of GaN, an n-type layer (a contact layer and a clad layer) 23 made of GaN, an active layer (a light emitting layer) 24 made of, for example, an InGaN based compound semiconductor (which means that a ratio of In to Ga can be varied variously and the same applies hereinafter), which has a smaller band gap than that of the clad layer and decides a wave length of light emitted, and a p-type layer (a clad layer) 25 made of p-type GaN, are laminated by an epitaxial growth technique in this order, and on its surface, an upper electrode (a p-side electrode) 28 is formed interposing a light transmitting conductive layer made of, for example, ZnO or the like. And a lower electrode (an n-side electrode) 29 is formed on an exposed surface of the n-type layer 23 formed by removing a part of the semiconductor lamination portion by etching. The upper electrode 28 is formed with a lamination structure of Ti and Au, and the lower electrode 29 is formed by depositing a film directly made of an alloy of Ti and Al, or by forming an alloy of Ti and Al by applying a thermal treatment (an annealing) to a Ti film and an Al film laminated respectively, and then both electrodes are made of metal layers.

Furthermore, an AlGaN based compound semiconductor (which means that a ratio of In to Ga can be varied variously and the same applies hereinafter) may be employed at least on a side of the active layer 24 of the n-type layer 23 and the p-type layer 25 in order to increase an effect of carrier confinement. And, as it is difficult to increase a carrier density in the p-type layer in gallium nitride based compound semiconductor, generally, and as it is necessary to have an activation treatment of the p-type layer 25, the p-type layer is formed on a side of a surface of the semiconductor lamination portion.

In this structure, the electric current flows through the light transmitting conductive layer 27, and across the p-type layer 25, the active layer 24 and the n-type layer, by applying a voltage between the p-side electrode 28 and the n-side electrode 29, and light is emitted by recombination of electrons and holes in the active layer 24. But in gallium nitride based compound semiconductor layers, especially in p-type layers, a density of carriers can not be raised sufficiently, therefor it is difficult that the electric current diffuses in an entire chip. Therefore, as shown in Fig. 5, the light transmitting conductive layer 27 is formed on a surface of the p-type layer, so as to disperse the electric current to the entire chip while transmitting light. Thereafter, the upper electrode (the electrode pad) 28 is formed on the light transmitting conductive layer 27.

And also in this structure, as adhesion of the light transmitting conductive layer 27 and the p-type layer 25, and adhesion of the upper electrode 28 and the light transmitting conductive layer 27 are inferior in strength, there exist problems such that a relief occurs between the light transmitting conductive layer 27 and the p-type layer 25, or that peeling of a portion of the upper electrode 28 occurs at a top side or a back side of the light transmitting conductive layer 27, when wire bonding is performed on the upper electrode 28. In order to solve the above described problems, for example, a structure has been suggested (cf. for example PATENT DOCUMENT 1), wherein by removing a part of the light transmitting conductive layer 27 where the upper electrode 28 is formed, the upper electrode 28 is formed so as to get a direct contact with the p-type layer 25, employing a material with which adhesion of the upper electrode 28 and the p-type layer 25 is superior to adhesion of the light transmitting conductive layer 27 and the p-type layer 25.
PATENT DOCUMENT 1: Japanese Patent Application Laid-Open No. HEI07-94782

### DISCLOSURE OF THE INVENTION

### PROBLEM TO BE SOLVED BY THE PRESENT INVENTION

As described above, when the upper electrode is formed on the light transmitting conductive layer, a problem of a relief or peeling of the light transmitting conductive layer arises upon wire bonding or the like, and at the same time, another problem arises such that light emitted can not be used efficiently, because light which emits in the active layer and travels upward can not transmit the upper electrode and goes to waste by absorptions or repeated reflections, because electric current flows uniformly under the upper electrode. On the other hand, in case of forming an opening in a part of the light transmitting conductive layer and forming the upper electrode at the opening, a problem also arises such that light traveling upward goes to waste by intercepting at the upper electrode, because a little electric current flows from the upper electrode to the p-type layer directly and light is emitted under the upper electrode, although an ohmic contact of the upper electrode and the p-type layer is inferior. This tendency described above becomes more remarkable, when the electric current flowing from the upper electrode to the p-type layer increases relatively, because adhesion of the light transmitting conductive layer and the p-type layer is deteriorated by wire bonding or the like.

On the other hand, in case of AlGaAs based compound semiconductors or InGaAlP based compound semiconductors, it has been attempted to prevent the electric current from flowing under the upper electrode by inserting insulating materials under the upper electrode or by forming a different conductivity type layer. But in gallium nitride based compound semiconductors, as a damage caused by a plasma during forming an insulating film and etching the insulating film by a dry-etching technique, deteriorates a property of an ohmic contact of a region where the upper electrode is not formed, an electric current blocking means of same kinds as described above can not be employed.

The present invention is directed to solve the above-described problems and an object of the present invention is to provide a semiconductor light emitting device employing gallium nitride based compound semiconductor, in which external quantum efficiency is enhanced by suppressing emission of light under the upper electrode, and good adhesion of the upper electrode and the semiconductor layer is ensured.

Another object of the present invention is to provide a method for manufacturing a semiconductor light emitting device in which an electric current blocking means to prevent an electric current from flowing exclusively under the upper electrode is formed without giving any influences to other portions, and thereby external quantum efficiency is enhanced.

### MEANS FOR SOLVING THE PROBLEM

A semiconductor light emitting device according to the present invention has a structure including a semiconductor lamination portion formed by laminating at least an n-type layer and a p-type layer made of gallium nitride based compound semiconductor so as to form a light emitting portion, a light transmitting conductive layer formed on a surface of the semiconductor lamination portion, and an upper electrode formed so as to be in contact with an exposed surface of the semiconductor lamination portion formed by removing a part of the light transmitting conductive layer and with the light transmitting conductive layer, wherein an electric current blocking means is formed on the exposed surface of the semiconductor lamination portion which is formed by removing a part of the light transmitting conductive layer, thereby preventing electric current from flowing into a part under the upper electrode while ensuring good adhesion between the upper electrode and the surface of the semiconductor lamination portion.

Here, gallium nitride based compound semiconductor means a compound of Ga of group III element and N of group V element or a nitride compound in which a part or all of Ga of group III element is substituted by other element of group III element like Al, In or the like and/or a part of N of group V element is substituted by other element of group V element like P, As or the like.

The electric current blocking means can be a recessed portion formed on the exposed surface of the semiconductor lamination portion which is formed by removing the light transmitting conductive layer, or can be an oxygen containing layer formed on the exposed surface of the semiconductor lamination portion which is formed by removing the light transmitting conductive layer.

A method for manufacturing a semiconductor light emitting device according to the present invention includes a step of forming a semiconductor lamination portion by laminating gallium nitride based compound semiconductor layers so as to form a light emitting portion including an n-type layer and a p-type layer on a substrate, a step of forming a light transmitting conductive layer on the semiconductor lamination portion, a step of exposing a surface of the semiconductor lamination portion by etching a part of the light transmitting conductive layer where an upper electrode is planning to be formed, a step of forming an electric current blocking means by exposing the exposed surface of the semiconductor lamination portion which is exposed by the etching to an oxygen plasma, and a step of forming an upper electrode so as to adhere to the exposed surface of the semiconductor lamination portion formed as the electric current blocking means and to a vicinity of an opening of the light transmitting conductive layer.

Another embodiment of a method for manufacturing a semiconductor light emitting device according to the present invention includes, instead of the steps of exposing to the oxygen plasma and forming the upper electrode, a step of forming a recessed portion on the exposed surface of the semiconductor lamination portion by a dry etching, and a step of forming an upper electrode so as to adhere to an exposed surface in the recessed portion and to the vicinity of the opening of the light transmitting conductive layer.

### EFFECT OF THE INVENTION

The semiconductor light emitting device according to the present invention is formed by forming the light transmitting conductive layer on the surface of the semiconductor lamination portion made of gallium nitride based compound semiconductor, in which semiconductor layers are laminated so as to form the light emitting portion, forming the electric current blocking means on the exposed surface of the semiconductor lamination portion formed by removing the part of the light transmitting conductive layer where the upper electrode is formed, and forming the upper electrode so as to adhere to the exposed surface of the semiconductor lamination portion. Therefore, the electric current flowing into a part under the upper electrode can be almost prevented, thereby preventing light from emitting under the upper electrode where the light can not be taken out of a surface even if the light is emitted, while ensuring good adhesion between the upper electrode and the surface of the semiconductor lamination portion. Consequently, the external quantum efficiency is enhanced significantly, as emitting useless light is suppressed and light can be taken out efficiently.

And by the method for manufacturing the semiconductor light emitting device according to the present invention, as the semiconductor lamination portion is exposed by removing a part of the light transmitting conductive layer where the upper electrode is formed, and exposed to the oxygen plasma after forming the light transmitting conductive layer on the surface of the semiconductor lamination portion, there can be obtained the electric current blocking means which is very effective to block the electric current since oxygen from the oxygen plasma is taken into the surface (being oxidized) of the gallium nitride based compound semiconductor layer. On the contrary, as a rest part, where the upper electrode is not formed and the light transmitting conductive layer is not removed, is covered with the light transmitting conductive layer which does not receive any influence even if exposed to the oxygen plasma, any influence can not be given to the electric current from the light transmitting conductive layer. Namely, in a method applied in a GaAs based semiconductor light emitting device by the prior art, in which a conductivity type of a semiconductor layer is changed partially or an insulating layer is formed partially in order to block the electric current partially, as it is necessary to make a partial mask made of an insulating film or the like, a property of ohmic contact of a portion, where an electric current is not blocked, is deteriorated during forming the mask or removing it by a dry etching technique. But by a method for manufacturing according to the present invention, the part of the semiconductor lamination portion except a portion, where the upper electrode is formed, is covered still with the light transmitting conductive layer, and the electric current blocking means is provided only to the portion where the upper electrode is formed, the rest part except the portion where the upper electrode is formed can not be given any influences.

Not only by exposing to the oxygen plasma but also by etching the exposed surface of the semiconductor lamination portion by a dry etching technique, the electric current is blocked significantly because the surface of the semiconductor lamination portion is ruined by Ar ions or the like of the dry etching. In this case, the part except the portion where the upper electrode is formed is covered with the light transmitting conductive layer, and as the light transmitting conductive layer made of Ni-Au, ZnO or the like is harder to etch than GaN based compounds, the semiconductor lamination portion is not given any influence and the electric current blocking means can be formed only under the upper electrode.

### BRIEF DESCRIPTION OF THE DRAWINGS

Figs. 1A and 1B show a perspective view and a plane view of a cross section explaining an embodiment of the semiconductor light emitting device according to the present invention.
Fig. 2 is a cross-sectional view explaining another embodiment of an electric current blocking means of the semiconductor light emitting device shown in Fig. 1.
Figs. 3A through 3C are figures showing a characteristics of voltage (V) versus electric current (I) in case that a surface of GaN layer is etched by a dry etching technique.
Figs. 4A through 4D show a manufacturing process of the semiconductor light emitting device shown in Fig. 1.
Fig. 5 shows a cross-sectional view explaining an example of a semiconductor light emitting device by the prior art.

### EXPLANATION OF LTTERS AND NUMERALS

- 3:: n-type layer
- 4:: active layer
- 5:: p-type layer
- 6:: semiconductor lamination portion
- 7:: light transmitting conductive layer
- 8:: upper electrode
- 9:: lower electrode
- 10:: electric current blocking means
- 10a:: recessed portion

### THE BEST EMBODIMENT OF THE PRESENT INVENTION

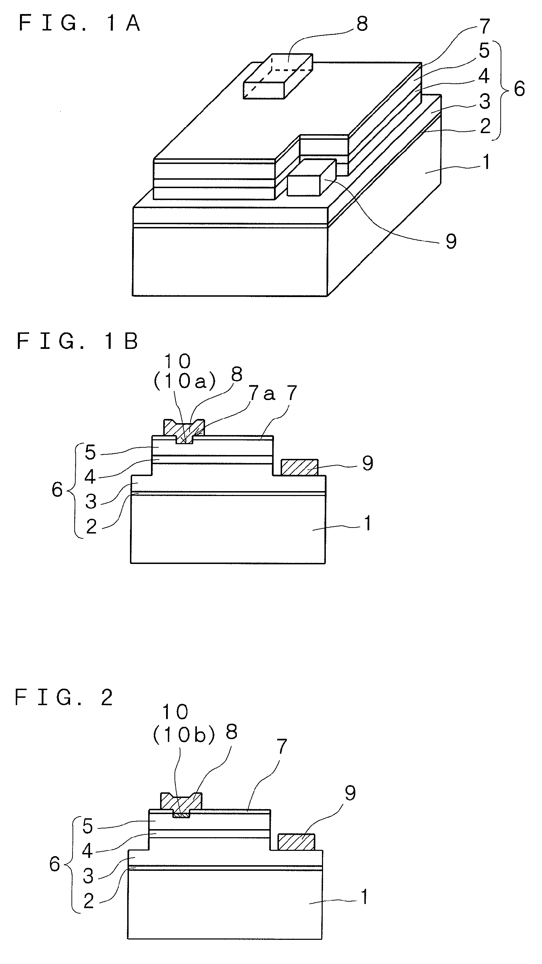

An explanation will be given below of a semiconductor light emitting device and a method for manufacturing the same according to the present invention in reference to the drawings. The semiconductor light emitting device according to the present invention, as a perspective view and a plane view of a cross section explaining one of its embodiments are shown in Fig. 1, includes a semiconductor lamination portion 6 formed by laminating an n-type layer 3 and a p-type layer 5 made of gallium nitride based compound semiconductor so as to form a light emitting portion, and a light transmitting conductive layer 7 formed on a surface of the semiconductor lamination portion 6. And an upper electrode (an electrode pad) 8 is formed so as to be in contact with an exposed surface of the semiconductor lamination portion 6 formed by removing a part of the light transmitting conductive layer 7, and with the light transmitting conductive layer 7. In the present invention, an electric current flowing into a part of the semiconductor layer under the upper electrode 8 is prevented significantly while ensuring good adhesion between the upper electrode 8 and the surface of the semiconductor lamination portion 6, by forming an electric current blocking means 10 (10a) on an exposed surface through an opening portion 7a, of the semiconductor lamination portion 6 which is formed by removing a part of the light transmitting conductive layer 7.

The electric current blocking means 10 can be a recessed portion 10a formed on the surface of the semiconductor lamination portion 6 which is exposed by removing the light transmitting conductive layer 7, or, as shown in Fig. 2, can be an oxygen containing layer 10b formed on the surface of the semiconductor lamination portion 6 which is exposed by removing the light transmitting conductive layer 7.

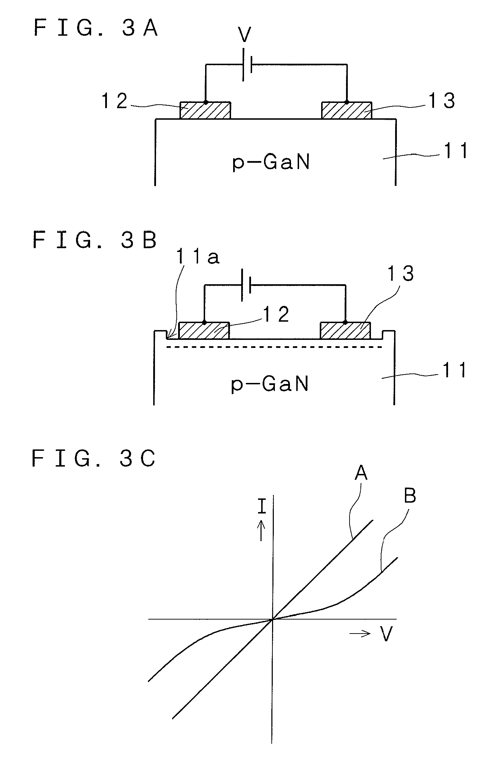

The present inventors have discovered and verified a fact that an electric current does not flow easily in between two metal films which are formed on a surface of a p-type gallium nitride based compound semiconductor etched by a dry etching technique or exposed to an atmosphere of oxygen plasma. Namely, a variation of an electric current to that of voltage has been examined, applying voltage between a pair of electrodes 12 and 13 in both cases that, as shown in Fig. 3A, the pair of electrodes 12, 13 are formed directly on a surface of the p-type GaN layer 11 by a conductive layer like ZnO which is easy to make an ohmic contact with the p-type GaN layer, and that, as shown in Fig. 3B, a recessed portion 11a is formed by etching the surface of the p-type GaN layer 11 by a dry etching technique to a depth of several tens of nano-meters (nm). As a result of this, it has been discovered, as shown in Fig. 3C, that a voltage-current characteristics is linear and an electric current increases with voltage in case A in which the electrodes 12, 13 are formed without etching the surface of the p-type GaN layer 11, and that the voltage-current characteristics is non-linear and little electric current flows to a low voltage of approximately 3 to 5 V in case B in which the electrodes 12, 13 are formed after applying dry etching on the surface of the p-type GaN layer 11.

Although patterning the conductivity layer made of ZnO or the like is necessary in order to make the pair of the electrodes 12 and 13, as dilute hydrochloric acid or the like used as an etchant does not give any damage or influence to the surface of GaN layers 11, ohmic contact is obtained as shown by A in Fig. 3C. In other word, a difference in electric contact of the electrodes 12, 13 and the p-type GaN layer 11 is represented in Fig. 3C.

A reason of this fact is supposed that a crystal structure of the p-type GaN layer 11 receives damage by a bombardment by Ar ions or the like during dry etching, and that mobility of carriers is restrained. The above-described phenomena occurs typically relating to a property of difficulty in increasing a carrier density of a p-type gallium nitride based compound semiconductor layer, and it is supposed that the above-described phenomena can not be observed in GaAs based compound semiconductor (AlGaAs based or InGaAlP based), but specifically observed in gallium nitride based compound semiconductor layer. The above-described property of electric contact of the electrodes and the p-type GaN layer is observed in case in which the surface of the p-type GaN layer 11 is exposed to the oxygen plasma instead of dry etching by ion bombardment. Namely, as a result of applying voltage, in the same way, between the pair of electrodes formed with ZnO layer in the same way shown in Fig. 3B after exposing the surface of the p-type GaN layer 11 to the oxygen plasma for 30 minutes, the property same as B shown in Fig. 3C has been observed. It is supposed that mobility of carriers are restrained, not by an ion bombardment like in dry etching, but by appearance of Ga which reacts with oxygen taken into the GaAs layer from an atmosphere.

The present invention is characterized in that the upper electrode (the electrode pad) is formed so as to contact with the surface of the semiconductor lamination portion exposed by removing a part of the light transmitting conductive layer, and that the electric current blocking means 10 of non-ohmic contact is formed, by utilizing the above-described phenomena, on a portion of a surface of semiconductor lamination portion where the upper electrode contact. Namely, when a conventional way used in GaAs based compounds, in which an insulating layer or a conductive layer having a different conductivity type from that of neighbor conductive layers is formed at a portion where an electric current blocking means is expected to be formed, is employed to gallium nitride based compound semiconductor, especially a p-type gallium nitride based compound semiconductor layer, there occurs a problem such that an ohmic contact between the light transmitting conductive layer and a semiconductor layer can not be obtained, because a conductivity of a surface of the p-type semiconductor layer or the like except a portion where an electric current is expected to be blocked is reduced, even if the light transmitting conductive layer is formed on the surface. But by the electric current blocking means according to the present invention, as the electric current blocking means is formed, as it is, on the exposed surface of the semiconductor layer exposed by removing only a part of the light transmitting conductive layer where the upper electrode is planning to be formed and where electric current is blocked, after forming the light transmitting conductive layer, the upper electrode and the exposed surface of the semiconductor lamination portion makes a non-ohmic contact, thereby the electric current is blocked only under the upper electrode and a good ohmic contact can be obtained in other portion.

In an example shown in Fig. 1, after forming the opening portion 7a by removing a part of the light transmitting conductive layer 7 where the upper electrode 8 is planning to be formed, the recessed portion 10a is formed as the electric current blocking means 10 by etching the exposed surface of the semiconductor lamination portion 6 through the opening portion 7a, by a dry etching technique. Namely, by applying dry etching by Ar ions and Cl₂ gas to whole surface including the light transmitting conductive layer 7, the exposed surface through the opening portion 7a of the semiconductor lamination portion 6 is etched to a depth of 10 to 50 nm and the recessed portion 10a is formed, without giving any influence to the light transmitting conductive layer 7 and the semiconductor lamination portion 6 under the light transmitting conductive layer 7. And on an inside surface of the recessed portion 10a and covering an upper part of the light transmitting conductive layer around the opening portion 7a, the upper electrode (the electrode pad) 8 is formed in a lamination structure of a Ti layer having a thickness of approximately 0.01 to 0.05 µm and an Au layer having a thickness of 0.2 to 1 µm. A property of the ohmic contact of the surface of the recessed portion 10a, as shown by the above-described B in the Fig. 3C, with a material of electrodes is decreased and electric current hardly flows.

As mentioned above, this electric current blocking means 10 can also be obtained by forming an oxygen containing layer (an oxide layer) by exposing to the oxygen plasma instead of forming the recessed portion 10a by dry etching. The example is shown in Fig. 2. In Fig. 2, a reference numeral 10b represents the oxide layer formed by exposing the surface of the semiconductor lamination portion 6, and, as mentioned above, by exposing a part of the semiconductor lamination portion 6 formed by opening a part of the light transmitting conductive layer 7 where the upper electrode 8 is planning to be formed, and by leaving whole of the semiconductor portion in an atmosphere of, for example, oxygen (O₂) gas with a plasma source power of 200 to 400 W for 5 to 30 minutes, an oxide layer 10b is formed at the exposed surface of the semiconductor lamination portion 6 and works as the electric current blocking means 10. Others such as the upper electrode 8 or the like are formed in the same way as the sample shown in Fig. 1.

Structures except a structure in which the upper electrode 8 is formed on the surface of the semiconductor lamination portion 6 directly, through this electric current blocking means 10, are formed in the same way as that in gallium nitride based compound semiconductor light emitting devices by the prior art. In the example shown in Fig. 1, a sapphire (a single crystal of Al₂O₃) substrate, whose principal plane is a C plane, is used as the substrate 1, but not limited to this, a sapphire substrate whose principal plane is other plane can be employed. And the substrate 1 can be an insulating substrate, but semiconductor substrates like silicon carbide (SiC), GaN, GaAs, Si or the like are acceptable, too. In case of using an insulating substrate as the substrate 1, as an electrode can not be taken out from a back face of the substrate, it is necessary, as described below, to expose a conductive layer (an n-type layer 3 in Fig. 1) by removing a part of the semiconductor lamination portion 6 by etching.

In the example shown in Fig. 1, the semiconductor lamination portion 6 is formed with a buffer layer 2, an n-type layer 3, an active layer 4 and a p-type layer 5. The buffer layer 2 is formed in case that a difference in lattice constants of the substrate and the semiconductor layer laminated on it is large or that it is hard to laminate the gallium nitride based compound semiconductor layer on the substrate 1 with a good crystal structure. If a problem described above does not exist, the buffer layer is not necessary. For example, the buffer layer is formed with a compound having a composition of AlₓGa_{y}In_{1-x-y}N (0≤x≤1, 0≤y≤1 and 0≤x+y≤1, for example, x=1 and y=0) at a low temperature of approximately 400 to 600 °C. In the example shown in Fig. 1, a lamination portion forming a light emitting layer has a structure of a double hetero junction where the active layer 4 is sandwiched by the n-type layer 3 and the p-type layer, but, not limited to this, a structure of a p-n junction of a homo junction or single hetero junction type can be allowed. The semiconductor layers forming the light emitting layer are formed at a high temperature of approximately 700 to 1000 °C. Generally, the p-type layer is occasionally formed upper side of the active layer in order to activate the p-type layer, but a structure in which the p-type layer is formed down side and the n-type layer is formed upper side, can be used.

Although an example in which the n-type layer 3 and the p-type layer 5 are formed with a single layer is shown in the example shown in Fig. 1, generally, for example, they are formed with a structure where a GaN layer with which it is easy to enhance a carrier density is formed as a contact layer at an electrode forming portion, and where, occasionally, an AlGaN based compound which has a larger band gap energy than that of the active layer is employed in order to confine carriers easily at a side of the active layer, and furthermore they can be formed with a multilayer structure to give other functions. And a structure with a superlattice can be applied in order to laminate layers of different lattice constants. But a single layer which has the above described functions can be employed. And although a thickness of each layer is set depending upon objects respectively, for example, the n-type layer 3 is formed having a thickness of approximately 3 to 10µm in total, and the p-type layer 5 is formed having a thickness of approximately 0.1 to 1 µm in total. In addition, the n-type layer 3 is formed by doping gallium nitride based compound semiconductor with dopants such as Se, Si, Ge, Te or the like and the p-type layer 5 is formed by doping the same with dopants such as Mg, Zn or the like.

It is preferable that an activation treatment is applied to the p-type layer 5, because a p-type dopant such as Mg or the like hardly works as a dopant due to reaction with hydrogen (H). The activation treatment is achieved by a thermal treatment in, for example, a N₂ atmosphere, at a temperature of 600 to 800 °C and for approximately 10 minutes to one hour, but, not limited to this, an electron irradiation technique or the like can be employed. And, in the activation treatment, protective films may be formed on a surface of the p-type layer or may not be formed.

The active layer 4 is formed having a thickness of approximately 0.01 to 0.2 µm in total, by selecting a material having a band gap energy corresponding to a wave length of light emitted and with a bulk structure made of In_{0.15}Ga_{0.85}N or with a structure of a single or multiple quantum well formed with a well layer made of InGaN and a barrier layer made of GaN, for example, in case of emitting a blue light having a wave length of 460 to 470 nm. The active layer 4 is formed with a non-doped material, but a p-type or an n-type can be used.

The light transmitting conductive layer 7 is formed having a thickness of approximately 2 to 100 nm by alloying Ni and Au previously laminated or with a ZnO layer, an ITO layer or the like which is light transmitting, conductive to disperse the electric current to whole surface of a chip, and easy to get an ohmic contact with the p-type layer 5.
The ZnO layer or the ITO layer is formed having a thickness of approximately 0.3 to 2µm, because they transmit light even if thick. In the example shown in Fig. 1, the ZnO layer having a thickness of approximately 0.3 µm is formed as the light transmitting conductive layer 7.

In the example shown in Fig. 1, the upper electrode 8 is formed, as a p-side electrode because the p-type layer 5 exists on a top side of the semiconductor lamination portion 6, with a lamination structure made of, for example, Ti/Au, Pd/Au, Ni/Au or the like and having a thickness of approximately 0.2 to 1µm in total. The lower electrode (an n-side electrode) 9 is formed with an alloy layer made of, for example, Ti-Al, Ti-Au or the like, and having a thickness of approximately 0.2 to 1µm in total.

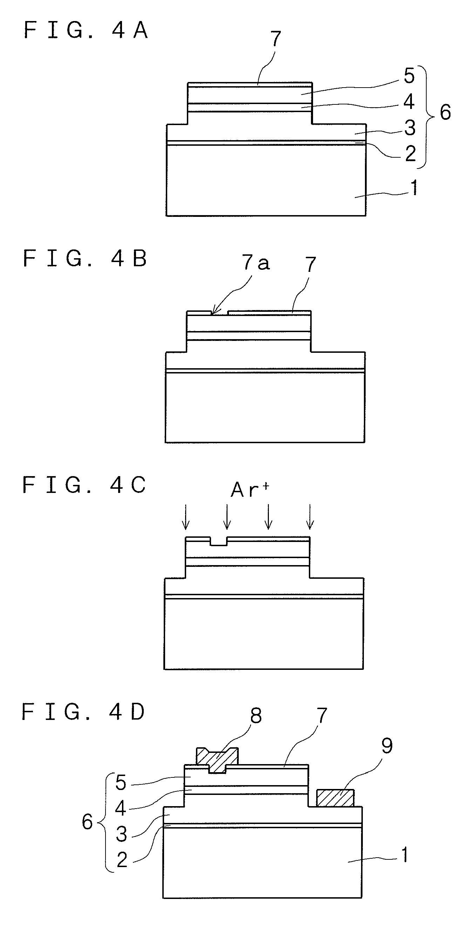

And next, an explanation will be given below of a method for manufacturing the semiconductor light emitting device shown in Fig. 1, in reference to Fig. 4. At first, a substrate 1 is set in an equipment for MOCVD (metal organic compound vapor deposition), and supplies, with H₂ or N₂ as a carrier gas, gasses containing components of a semiconductor layer to be grown, such as trimethyl gallium (TMG), trimethyl indium (TMI) and ammonia (NH₃), one of H₂Se, SiH₄, GeH₄ or TeH₄ as an n-type dopant gas, and a necessary one of dimethyl zinc (DMZn) or biscyclopentadienyl magnesium (Cp₂Mg) as a p-type dopant gas. And as shown in Fig. 4A, the buffer layer 2 made of, for example, GaN is formed having a thickness of approximately 0.01 to 0.03 µm at a temperature of approximately 400 to 600 °C . Succeedingly, the semiconductor lamination portion 6 is formed by growing, with an epitaxial growth technique, the n-type layer 3 made of an n-type GaN based layer having a thickness of 2 to 10 µm and an n-type AlGaN based layer having a thickness of 0.1 to 0.8 µm, an active layer 4 made of InGaN based layer having a thickness of 0.01 to 0.1 µm, and the p-type layer 5 made of a p-type AlGaN based layer having a thickness of 0.05 to 0.4 µm and of a p-type GaN based layer having a thickness of 0.05 to 0.5 µm, sequentially in this series.

Thereafter, the p-type layer 5 is activated by heating in a N₂ atmosphere at a temperature of approximately 600 to 800 °C for approximately 30 minutes. Subsequently, the light transmitting conductive layer 7 is formed by forming a ZnO layer having a thickness of approximately 0.4 to 1 µm by an evaporating technique, a sputtering technique or the like. And a part of the n-type layer 3 is exposed in order to form the lower electrode (the n-side electrode) 9, by etching the semiconductor lamination portion 6 at a part of a chip by a reactive ion-etching technique with chlorine gas. At this time, there is a case that, as shown in Fig. 1A, the semiconductor lamination portion 6 at a vicinity of a border portion for dividing a wafer into chips, is etched, but etching the part of the border is not always necessary. Thereafter, as shown in Fig. 4B, the opening portion 7a is formed in the light transmitting conductive layer 7, by forming a photo-resist film on the surface, forming an opening at a place where the upper electrode (the p-side electrode) is planning to be formed, and removing a part of the light transmitting conductive layer 7 which is exposed through the opening of the photo-resist film, by etching with an etchant like dilute hydrochloric acid or the like. And subsequently, the recessed portion 10a is formed on an exposed surface of the semiconductor lamination portion 6 through the opening portion 7a by etching by a dry etching technique with Ar and Cl₂ gas, as shown in Fig. 4C. A depth of this recessed portion 10a is approximately several tens of nano-meters (nm).

Thereafter, as shown in Fig. 4D, the upper electrode 8 is formed by depositing, for example by a lift-off technique, a Ti film having a thickness of approximately 0.1 µm and an Au film having a thickness of approximately 0.4 µm, respectively by an evaporation technique or the like, and the lower electrode (the n-side electrode) 9 is formed by depositing, in the same way, a Ti film having a thickness of approximately 0.1 µm and an Al film having a thickness of approximately 0.3 µm, and by sintering them to make an alloy. These, the upper electrode 8 and the lower electrode 9, are electrode pads to which lead terminals or the like are connected by wire bonding or the like. By dividing into chips, a chip shown in Fig. 1 is obtained.

In case of manufacturing a semiconductor light emitting device shown in Fig. 2, after forming the opening portion 7a in the light transmitting conductive layer 7 as described above, exposing to an atmosphere of oxygen plasma for approximately 10 to 30 minutes is employed in stead of the dry etching, and manufacturing processes followed is the same as described above.

In the semiconductor light emitting device according to the present invention, as the upper electrode is formed so as to adhere to the exposed surface of the semiconductor lamination portion formed by removing a part of the light transmitting conductive layer, and to the light transmitting conductive layer, and the electric current blocking means is formed at a contact region of the upper electrode and the surface of the semiconductor lamination portion, while ensuring good adhesion between the upper electrode and the surface of the semiconductor lamination portion, electrical contact between them is non-ohmic. As a result of this, when voltage is applied between the upper electrode 8 and the lower electrode 9, an electric current hardly flows into under the upper electrode 8, but flows in a surroundings of the semiconductor lamination portion through the light transmitting conductive layer 7. Then, in the active layer under the upper electrode 8, there hardly occurs a function of emitting light. Namely, although light emitted under the upper electrode and traveling upward goes to waste because the upper electrode made of metal does not transmit light, by the present invention, emission of light itself under the upper electrode hardly occurs. Consequently, external quantum efficiency is improved significantly due to not using useless electric current, because it is easy to take out light which has emitted and emission of light itself under the upper electrode, which is difficult to take out, is suppressed.

### INDUSTRIAL APPLICABILITY

The semiconductor light emitting device according to the present invention can be used for lighting sources in a broad field such as back-lights of liquid crystal displays, kinds of light emitting devices like white color or blue color type, kinds of lighting apparatus or the like.

## Claims

1. A semiconductor light emitting device comprising:
a semiconductor lamination portion formed by laminating at least an n-type layer and a p-type layer made of gallium nitride based compound semiconductor so as to form a light emitting portion;
a light transmitting conductive layer formed on a surface of the semiconductor lamination portion; and
an upper electrode formed so as to be in contact with an exposed surface of the semiconductor lamination portion formed by removing a part of the light transmitting conductive layer, and with the light transmitting conductive layer,
wherein an electric current blocking means is formed on the exposed surface of the semiconductor lamination portion which is formed by removing a part of the light transmitting conductive layer, thereby preventing electric current from flowing into a part under the upper electrode while ensuring good adhesion between the upper electrode and the surface of the semiconductor lamination portion.

2. The semiconductor light emitting device according to claim 1, wherein the electric current blocking means is a recessed portion formed on the exposed surface of the semiconductor lamination portion which is formed by removing the light transmitting conductive layer.

3. The semiconductor light emitting device according to claim 1, wherein the electric current blocking means is an oxygen containing layer formed on the exposed surface of the semiconductor lamination portion which is formed by removing the light transmitting conductive layer.

4. The semiconductor light emitting device according to claim 3, wherein the recessed portion is formed with a depth of 10 to 50 nm.

5. A method for manufacturing a semiconductor light emitting device comprising steps of:
forming a semiconductor lamination portion by laminating gallium nitride based compound semiconductor layers so as to form a light emitting portion including an n-type layer and a p-type layer on a substrate;
forming a light transmitting conductive layer on the semiconductor lamination portion;
exposing a surface of the semiconductor lamination portion by etching a part of the light transmitting conductive layer where an upper electrode is planning to be formed;
forming an electric current blocking means by exposing the exposed surface of the semiconductor lamination portion which is exposed by the etching to oxygen plasma; and
forming an upper electrode so as to adhere to the exposed surface of the semiconductor lamination portion formed as the electric current blocking means and to a vicinity of an opening of the light transmitting conductive layer.

6. The method for manufacturing a semiconductor light emitting device according to claim 5, further comprising the steps instead of the steps of exposing to the oxygen plasma and forming the upper electrode:
forming a recessed portion on the exposed surface of the semiconductor lamination portion by a dry etching; and
forming an upper electrode so as to adhere to an exposed surface in the recessed portion and to a vicinity of an opening of the light transmitting conductive layer.

7. The method for manufacturing a semiconductor light emitting device according to claim 5, wherein treating by the oxygen plasma is applied with a plasma source power of 200 to 400 W for 5 to 30 minutes.
